Europäisches Patentamt

European Patent Office

Office européen des brevets

(19)

(11) **EP 0 739 536 B1**

(12) **EUROPÄISCHE PATENTSCHRIFT**

(45) Veröffentlichungstag und Bekanntmachung des Hinweises auf die Patenterteilung:
**01.08.2001 Patentblatt 2001/31**

(51) Int Cl.⁷: $H01L\ 21/266$, H01L 21/263, H01J 37/30, H01J 37/317

(21) Anmeldenummer: **95904350.6**

(22) Anmeldetag: **12.01.1995**

(86) Internationale Anmeldenummer:
**PCT/AT95/00004**

(87) Internationale Veröffentlichungsnummer:
**WO 95/19640 (20.07.1995 Gazette 1995/31)**

(54) **PROJEKTIONSSYSTEM FÜR GELADENE TEILCHEN**

CHARGED PARTICLE PROJECTOR SYSTEM

SYSTEME PROJECTEUR DE PARTICULES CHARGEES

(84) Benannte Vertragsstaaten:
**DE**

(30) Priorität: **13.01.1994 AT 4694**

(43) Veröffentlichungstag der Anmeldung:
**30.10.1996 Patentblatt 1996/44**

(73) Patentinhaber: **IMS Ionen Mikrofabrikations Systeme Gesellschaft m.b.H.
A-1020 Wien (AT)**

(72) Erfinder:
• **STENGL, Gerhard
  A-9241 Wernberg (AT)**
• **CHALUPKA, Alfred
  A-1170 Wien (AT)**
• **VONACH, Herbert
  A-3400 Klosterneuburg (AT)**

(74) Vertreter: **Rieberer, Stefan, Dipl.-Ing.
Patentanwalt,
Dipl.-Ing. Franz Matschnig,
Siebensterngasse 54
1071 Wien (AT)**

(56) Entgegenhaltungen:
**EP-A- 0 374 011          EP-A- 0 564 438
WO-A-94/03919          AT-A- 4 694
GB-A- 1 367 360**

## Beschreibung

Die Erfindung betrifft ein Projektionssystem für geladene Teilchen, insbesondere Ionen, mit einer im Strahlengang der geladenen Teilchen angeordneten Maske mit insbesondere asymmetrisch zur optischen Achse angeordneten transparenten Stellen, insbesondere Öffnungen, die unter Verwendung von im Strahlengang der geladenen Teilchen angeordneten Linsen auf einen Wafer abgebildet werden, wobei der Strahl der geladenen Teilchen zwischen der Maske und dem Wafer mindestens einen Cross-over (Kreuzung mit der optischen Achse) besitzt.

Bei Projektionssystemen dieser Art treten Probleme dadurch auf, daß bei gleicher Stromdichte an der mit den transparenten Stellen versehenen Maske, je nach Maske und Anordnung sowie Größe der transparenten Stellen, hinter der Maske unterschiedliche Ionenströme und Stromdichteverteilungen entstehen. Durch den sogenannten Raumladungseffekt, der durch die gegenseitige Beeinflussung der geladenen Teilchen nach deren Durchgang durch die transparenten Stellen der Maske auftritt, entstehen unterschiedliche Ablenkungen der geladenen Teilchen und damit von der Sollauftreffstelle abweichende Auftreffstellen (Istauftreffstellen) der geladenen Teilchen auf dem Wafer, was Maßstabsänderungen und Bildverzeichnungen bewirken kann.

Besonders gravierend werden diese Probleme, wenn die transparenten Stellen in der Maske bezüglich der optischen Achse extrem asymmetrisch angeordnet sind. Zur Lösung der dadurch bedingten Probleme wurde schon vorgeschlagen (Image Projection Ion-Beam Lithography von Paul A.Miller in SPIE Vol.1089 Electron-Beam, X-Ray, and Ion-Beam Technology Submicrometer Lithographies VIII (1989), Seiten 26 ff), Kompensationsöffnungen (bzw. transparente Bereiche) in der Maske anzubringen, um eine Anordnung von transparenten Bereichen (Öffnungen) zu erzielen, die wie eine bezüglich der ionenoptischen Achse symmetrische Anordnung von transparenten Bereichen (Öffnungen) wirkt.

Ein Nachteil dieser vorgenannten Maßnahme besteht darin, daß der Gesamtstrom ansteigt und damit die Wirkung der sogenannten stochastischen Raumladung, welche auf der direkten Coulomb-Wechselwirkung der zufällig verteilten Ionen beruht, erhöht wird, was eine Verschlechterung der maximal erreichbaren Auflösung zur Folge hat. Die stochastische Raumladung ist nach A.Weidenhausen, R.Spehr, H.Rose, Optik 69, S. 126-134, 1985, proportional zur Quadratwurzel des Gesamtstroms.

Abgesehen von diesem Nachteil ist auch auch die Berechnung der Größe und Anordnung der der Kompensation dienenden transparenten Bereiche auf der Maske schwierig.

Um das eingangs erwähnte Problem einer Lösung zuzuführen und Probleme zu vermeiden, die bei Anordnung von der Kompensation dienenden transparenten Bereiche auftreten, schlägt die Erfindung bei einem Projektionssystem für geladene Teilchen der eingangs genannten Art vor, zwischen der Maske und dem Wafer einen Spender von zu den abbildenden Teilchen entgegengesetzt geladenen Teilchen vorzusehen, z.B. eine Glühkathode, für Projektionssysteme, die mit positiv geladenen Ionen arbeiten, zur Zufuhr von entgegengesetzter Ladung in den Strahlengang der geladenen Teilchen. Außer für positive Ionen kann das erfindungsgemäße Projektionssystem auch zur Elektronenprojektion oder zur Projektion mit negativen Ionen, insbesondere negativen Wasserstoffionen, angewendet werden. Solche negative Ionen erlauben eine einfachere Massenseparation.

Die zwischen der Maske und dem Wafer zuzuführenden, elektrisch geladenen Teilchen haben entgegengesetzte Ladung wie die Teilchen des Hauptstrahles. Sind die abbildenden Teilchen positiv geladene Ionen, so werden als Teilchen mit dazu entgegengesetzter Ladung Elektronen eingesetzt. Sind die abbildenden Teilchen negativ geladene Ionen, insbesondere negative H-Ionen, so sind die Teilchen mit entgegengesetzter Ladung positiv geladene Ionen. Werden als abbildende Teilchen Elektronen eingesetzt, so sind die Teilchen mit entgegengesetzter Ladung positiv geladene Ionen. Die Zufuhr der Teilchen mit entgegengesetzter Ladung zur Ladung der Teilchen des Hauptstromes erfolgt in einem Bereich, dessen Grenzen durch die Forderung definiert sind, daß der Absolutbetrag der integralen Wirkung der Raumladung auf die die Maskenstrukturen abbildenden Teilchen, in Strahlrichtung gesehen, vor diesem Bereich genau so groß ist wie der Absolutbetrag der integralen Wirkung der Raumladung nach diesem Bereich.

Zur Vereinfachung soll im folgenden angenommen werden, daß es sich bei den abbildenden Teilchen (Hauptstrahl) um positiv geladene Ionen handelt und bei den zur Raumladungskompensation verwendeten Teilchen um Elektronen.

Für Projektionssysteme mit einem Crossover zwischen Maske und Wafer ist es dabei nicht notwendig, die Elektronen im gesamten Bereich zwischen Maske und Wafer zuzuführen, da sich die Wirkung vor und nach dem Crossover zum Teil ausgleicht. Da der Raumladungseffekt umso größer ist, je näher die Ionen beisammen sind, ist es am günstigsten, die Elektronen im Bereich um den Crossover zuzuführen.

In weiterer Ausgestaltung der Erfindung kann vorgesehen werden, daß zur Begrenzung des Bereiches, in dem neutralisierende Teilchen zugeführt werden, an jeder Seite des Bereiches, bevorzugt zu beiden Seiten des Crossovers, mindestens je eine mit einer Spannungsquelle in Verbindung stehende Blende angeordnet ist, deren Öffnung jenes Strahlenbündel durchläßt, welches die von den transparenten Stellen der Maske herrührenden Bildinformationen enthält. Zwischen den Blenden bildet sich hierbei, bedingt durch die Potentiale, welche den Blenden aufgeprägt werden, ein Käfig für die Elektronen aus, der deren Entweichen nach außen weitgehend vermeidet, sodaß diese ihre volle Wirksamkeit entfalten können.

Es können auch zu beiden Seiten des Cross-over jeweils eine Reihe von Blenden angeordnet werden. Das Potential an diesen Blenden kann verändert werden, womit der definierte Bereich für die Zufuhr der geladenen Teilchen für die Kompensation der Raumladung variiert werden kann. Die Öffnungen der Blenden können unterschiedlich sein, u.zw. derart, daß die dem Cross-over naheliegenden Blenden eine kleinere Öffnung besitzen als die vom Cross-over weiter entfernten Blenden. Die Größe der Blendenöffnungen ist jedoch, wie bereits erwähnt wurde, dem Querschnitt des Strahlenbündels anzupassen, das die von der Maske herrührenden Bildinformationen enthält, um die Bildinformation vollinhaltlich auf den Wafer zu bringen.

Als Elektronenspender kann z.B. eine LaB6-Kathode vorgesehen sein, beispielsweise ein den Ionenstrahl umgebender, indirekt beheizter LaB6-Zylinder. Oder es werden mit Hilfe einer Elektronenkanone, welche insbesondere 1 keV Elektronen durch eine Öffnung auf die Innenwand eines den Strahl umgebenden metallischen, insbesondere zylindrischen Schirmes aussendet, niederenergetische Sekundärelektronen generiert, welche den Ionenstrahl neutralisieren.

Wie bereits eingangs erwähnt, unterliegt ein elektrisch geladenes Teilchen (z.B. ein Ion), welches eine Maskenöffnung durchsetzt, dem Einfluß eines Feldes, das durch die anderen Ionen induziert wird, welche sich in Richtung auf die Waferebene in der teilchenoptischen Säule bewegen. Bei einer zunächst radial symmetrisch angenommenen Raumladung wirkt das von der Raumladung erzeugte Zusatzfeld überall rein radial. Ein geladenes Teilchen, welches ohne Raumladungseffekt den Wafer im Abstand R, Azimut φ erreichen würde, wird daher bei Berücksichtigung der Raumladung den Wafer zwar bei gleichem Azimut φ, aber in einem gewissen Abstand ΔR von der Sollauftreffstelle erreichen.

Die Abweichung ΔR kann mathematisch wie folgt ausgedrückt werden

$$\Delta R \quad = \quad \int_{z_m}^{z_w} \quad \frac{dR}{d\alpha}(z) \quad \cdot \quad \frac{d\alpha}{dz}(z) \quad \cdot \quad dz \qquad (1).$$

In der Gleichung (1) bedeutet $z_w$ die Ortskoordinate der Waferebene, $z_m$ die Ortskoordinate der Maskenebene, $\alpha$ den jeweiligen Winkel der Teilchenbahn mit der optischen Achse in z-Richtung (Fortpflanzungsrichtung des Strahles), $dR/d\alpha$ die Änderung der Strahlposition in der Waferebene aufgrund einer Winkeländerung am Ort z, $d\alpha/dz$ die durch die Raumladung bedingte Strahlrichtungsänderung entlang der teilchenoptischen Achse (z-Richtung).

Unter der Annahme, daß das Verhältnis der radialen Abstände je zweier Ionenbahnen entlang der optischen Achse konstant bleibt und daß die Geschwindigkeitskomponente in z-Richtung $v_z(Z)$ für alle Ionen identisch ist, daß also - in anderen Worten - die wirksame Ladungsmenge für jedes Teilchen entlang seiner Bahn immer gleich groß ist, ergibt sich für die durch die Faumladung bedingte Winkeländerung $d\alpha/dz$ der folgende analytische Ausdruck:

$$\frac{d\alpha}{dz} = c \cdot \frac{1}{r(z) \cdot v^3{}_z(z)} \qquad (2).$$

mit $\alpha = v_r/v_z$, wobei $v_r$ bzw. $v_z$ die Geschwindigkeitskomponenten der Teilchen in r- bzw. z-Richtung sind.

Der Wert dieser Funktion für beliebiges z kann mit Hilfe von Trajektorienrechnungen ermittelt werden. Die Änderung der Strahlposition dR auf der Waferebene aufgrund einer Winkeländerung dα am Ort z, dR/dα(z), kann ebenfalls über Trajektorienberechnungen herausgefunden werden, indem an genügend vielen z-Positionen die Rechnung unterbrochen, eine geringfügige Winkeländerung Δα aufgeprägt und danach bis zur Waferebene weitergerechnet wird.

Gleichung (2) zeigt, daß in der Umgebung des Crossovers die Annahme einer konstanten wirksamen Ladungsmenge für jedes Ion nicht zutrifft, da im Kreuzungspunkt, also bei r(z)=0, der Wert für dα/dz unendlich groß werden würde. Tatsächlich besitzen Linsensvsteme nie einen scharfen Kreuzungspunkt, was bedeutet, daß Gleichung (2) für die Umgebung des Kreuzungspunktes nicht gültig ist. Wenn jedoch genügend negativ geladene Teilchen, z.B. Elektronen, im Bereich des Crossovers zugeführt werden, so ist in diesem Bereich die Wirkung der Raumladung gleich Null. Dieser Bereich braucht daher bei der Berechnung des Integrals der Gleichung (1) nicht berücksichtigt zu werden.

Durch Zufuhr einer ausreichenden Zahl von Elektronen gelingt es, die Raumladung in einem Bereich $z_1 < z < z_2$ zu kompensieren. An den Stellen mit den Ortskoordinaten $z_1$ und $z_2$ vor bzw. hinter dem Ort $z_c$ des Cross-over werden Blenden angeordnet, die negativ vorgespannt werden, um sicherzustellen, daß keine Elektronen den zwischen $z_1$ und $z_2$ gelegenen Bereich um den Cross-over nach außen verlassen können. Da sich das Vorzeichen von dR/dα nach dem Crossover umkehrt und im Hinblick auf die Neutralisierung der Raumladung zwischen $z_1$ und $z_2$ kann Gleichung (1) wie folgt geschrieben werden:

$$\Delta R \quad = \quad \left| \int_{z_m}^{z_1} \frac{d\alpha}{dz} \cdot \frac{dR}{d\alpha} \cdot dz \right| \quad - \quad \left| \int_{z_2}^{z_w} \frac{d\alpha}{dz} \cdot \frac{dR}{d\alpha} \cdot dz \right| \qquad (3).$$

Die Ortskoordinaten $z_1$ und $z_2$ für die Blenden werden nun so gewählt, daß der Absolutbetrag der beiden Integrale der Gleichung (3) gleich wird, in welchem Fall die Abweichung $\Delta R$ verschwindet.

Diese Kompensation der Raumladungseffekte ist jedoch nicht auf radial symmetrische Raumladungsverteilung beschränkt.

Im Falle einer beliebigen Verteilung der Maskenöffnungen besitzt das Raumladungsfeld für eine bestimmte Teilchenladung sowohl eine radiale als auch eine azimutale Komponente. Das Teilchen wird also durch die Raumladung radial um $\Delta R$ und azimutal um den Winkel $\Delta\varphi$ bzw. die Strecke $R.\Delta\varphi$ abgelenkt.

Für die radiale Änderung $\Delta R$ gilt weiterhin Gleichung (1), für die azimutale Ablenkung $\Delta\varphi$ gilt analog

$$\Delta\varphi = \int_{z_m}^{z_w} \frac{d\varphi}{d\beta}(z) \cdot \frac{d\beta}{dz}(z) \cdot dz \qquad (4).$$

Dabei bedeutet $d\varphi/d\beta$ die azimutale Positionsänderung am Ort des Wafers als Folge der raumladungsbedingten Strahlrichtungsänderung $\beta$ senkrecht zum Hauptschnitt (Ebene durch Teilchenort und optische Achse) und $d\beta/dz$ die von der Raumladung hervorgerufene Änderung des Winkels $\beta$ pro Längeneinheit. Die Größen $dR/d\alpha$ und $d\varphi/d\beta$ bzw. $d\alpha/dz$ und $d\beta/dz$ hängen in einfacher Weise miteinander zusammen.

Im Falle einer rotationssymmetrischen Linse erzeugen kleine Winkeländerungen $\Delta\alpha$ und $\Delta\beta$ im Hauptschnitt bzw. senkrecht zu diesem, in erster Ordnung stets gleich große Ablenkungen $\Delta R$ bzw. $R\Delta\varphi$, also stets

$$\frac{dR}{d\alpha}(z) = R \cdot \frac{d\varphi}{d\beta}(z) \qquad (5)$$

für beliebige Werte von z.

Ebenso hängen $d\alpha/dz$ und $d\beta/dz$ sehr einfach zusammen, wenn wieder vorausgesetzt wird, daß das Verhältnis der radialen Abstände je zweier ungestörter Ionenbahnen entlang der optischen Achse konstant bleibt und zusätzlich vorausgesetzt wird, daß die ungestörten Ionenbahnen stets im Hauptschnitt verlaufen (was bei den verwendeten nahezu punktförmigen Ionenquellen sehr gut erfüllt ist). Dann erhält man für jede Ebene senkrecht zur optischen Achse eine ähnliche Ladungsverteilung und damit für eine bestimmte Ionenbahn stets ein Raumladungsfeld der gleichen Richtung, das sich an jeder Stelle z in gleicher Weise in eine radiale und azimutale Komponente zerlegen läßt. Damit gilt also

$$\frac{d\beta}{dz}(z) = c \cdot \frac{d\alpha}{dz}(z) \qquad (6).$$

wobei die Konstante c nicht von z abhängt, sondern nur durch die Form der Ladungsverteilung, d.h. von der Verteilung der Öffnungen in der Maske bestimmt wird.

Aus Gleichung (5) und (6) ergibt sich zusammen mit Gleichung (1) und (4), daß sowohl für $\Delta R$ als auch für $\Delta\varphi$ eine Kompensation der Raumladungseffekte zwischen passend gewählten Grenzen $Z_M$, $Z_1$ und $Z_2$, $Z_W$ vor und nach dem Cross-over eintritt. Es erfolgt, wegen Gleichung (5) und (6), diese Kompensation für $\Delta R$ und $\Delta\varphi$ bei denselben Blendenpositionen $z_1$. $z_2$. Eine sehr geringe Abweichung von dieser simultanen Kompensation wird lediglich durch den Astigmatismus der verwendeten Linsen verursacht, der zu geringfügigen Abweichungen gegenüber Gleichung (5) führt.

Eine genaue Übereinstimmung der absoluten Beträge der Integrale in Gleichung (3) und damit eine exakte Kompensation des Raumladungseffektes kann nur für einen bestimmten Wert von R, d.h. für eine bestimmte Sollauftreffstelle eines von einer Maskenöffnung kommenden Teilchenstrahles auf die Waferebene, erreicht werden. Da es nicht möglich ist, für verschiedene Werte von R unterschiedliche Werte für $z_1$ und/oder $z_2$ einzustellen, ändert sich der Ort des am Wafer auftreffenden Strahls für alle nicht vollständig kompensierten Werte von R mit der für die Abbildung verwendeten Stromstärke. Diese von R abhängige Änderung der Position des Strahls am Wafer bedeutet eine stromabhängige zusätzliche Verzeichnung. Sie ist durch die raumladungsbedingt geänderten Bahnen der Ionen in den Linsen zu erklären, womit sich die Wirkung der Linsen ändert. Dies hat zur Folge, daß die Kompensation der sphärischen Linsenfehler nicht mehr mit dem stromlosen Fall übereinstimmt.

In weiterer Ausgestaltung der erfindungsgemäßen Ausführungsform kann die Kompensation der sphärischen Linsenfehler durch stromabhängige Änderung der Brechkräfte der Linsen wiederhergestellt werden.

Rechnungen für ein Ionenprojektionssystem (österreichische Patentanmeldung A 47/94 der gleichen Anmelderin vom gleichen Tage) haben gezeigt, daß durch geringfügige Änderung der Linsenspannungen die Verzeichnung der Abbildung auf die selben Werte wie im theoretisch "stromlosen" Fall (ohne Raumladung) gebracht werden kann.

Auch für den Fall, daß sich der Crossover innerhalb einer Linse befindet und somit eine kontrollierte Zufuhr von entgegengesetzt geladenen Teilchen in diesem Bereich nicht möglich ist, kann eine Kompensation der globalen Raumladung nach dem erfindungsgemäßen Verfahren durchgeführt werden. Es gilt dann zwar Gleichung (2) im Bereich des Crossovers nicht und $d\alpha/dz$ muß in diesem Bereich auf eine andere Art bestimmt werden, z.B. durch Simulationsrechnung. Solange jedoch die Neutralisierungsgrenzen $z_1$ und $z_2$ so gewählt werden können, daß die beiden Absolutbeträge in Gleichung (3) gleich groß sind, erfolgt gemäß Gleichung (3) keine Änderung der Strahlposition am Wafer infolge von Raumladung.

Anhand der nachfolgenden Zeichnungen wird die Erfindung näher erläutert.

Es zeigt, Fig. 1 schematisch einen Ausschnitt eines Projektionssystems für geladene Teilchen zwischen Maske und Wafer, die Fig. 2 bis 5 Graphe verschiedener Funktionen für den zwischen Maske und Wafer gelegenen Bereich in der z-Richtung (Fortpflanzungsrichtung des Strahles als Ordinatenachse), und die Fig. 6a und 6b den berechneten Verlauf von Ionenbahnen in der Umgebung des Crossovers.

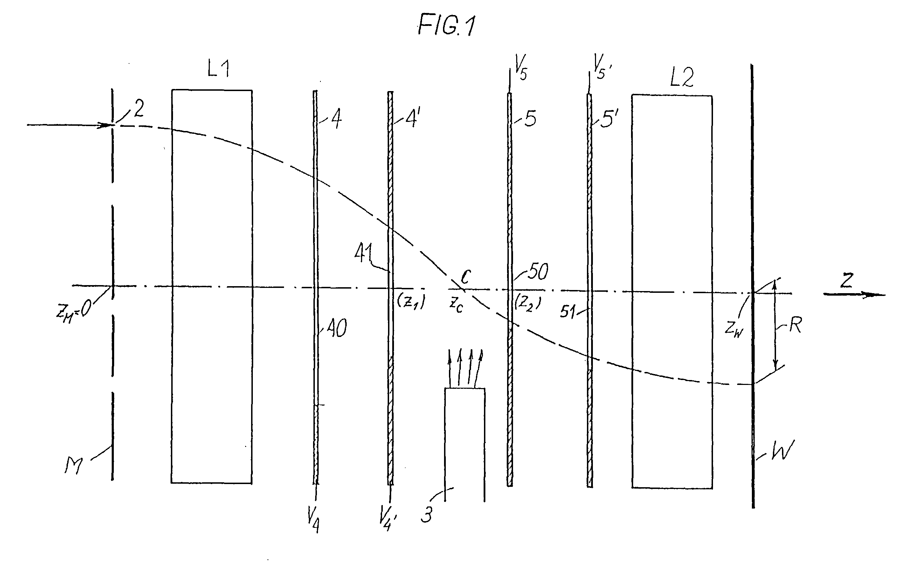

In Fig. 1 ist mit z die Fortpflanzungsrichtung des Teilchenstrahles bezeichnet. Mit M ist die Maske und mit W der Wafer bezeichnet. $Z_M$ ist dabei die Ortskoordinate der Maskenebene und $Z_W$ die Ortskoordinate der Waferebene. Mit 1 ist der Verlauf eines eine Öffnung 2 in der Maske M passierenden Strahles durch zwei Linsen L1 und L2 der optischen Säule dargestellt. C bezeichnet den Cross-over, d.h. den Kreuzungspunkt des Strahles mit der ionenoptischen (z-) Achse. Im Bereich des Cross-over C befindet sich eine Einrichtung 3, die dazu dient, Kompensationselektronen in den Strahlengang einzuführen. Mit 4 und 4' bzw. 5 und 5' sind Blenden dies- und jenseits des Cross-over C bezeichnete, die auf Potentialen V4, V4' bzw. V5 und V5' liegen. Die Blendenöffnungen 40, 41 bzw. 50, 51 sind dabei so groß zu wählen, daß alle Strahlen, welche Bildinformationen, resultierend aus den verschiedenen Öffnungen (transparenten Stellen) in der Maske M tragen, ungehindert passieren können. Die Potentialen V4 bis V5' werden so gewählt, daß die von der Einrichtung 3 zugeführten Elektronen aus dem Bereich zwischen den Blenden 4' und 5 bzw. 4 und 5' nicht entweichen können. R ist der Abstand, in dem der durch die Öffnung 2 hindurchgehende Strahl auf die Waferebene nach Ablenkung durch das Linsensystem L1 und L2 auftrifft. Der Darstellung liegt dabei die Annahme zugrunde, daß der Raumladungseffekt vollständig kompensiert wurde, d.h. $\Delta R$ verschwindet.

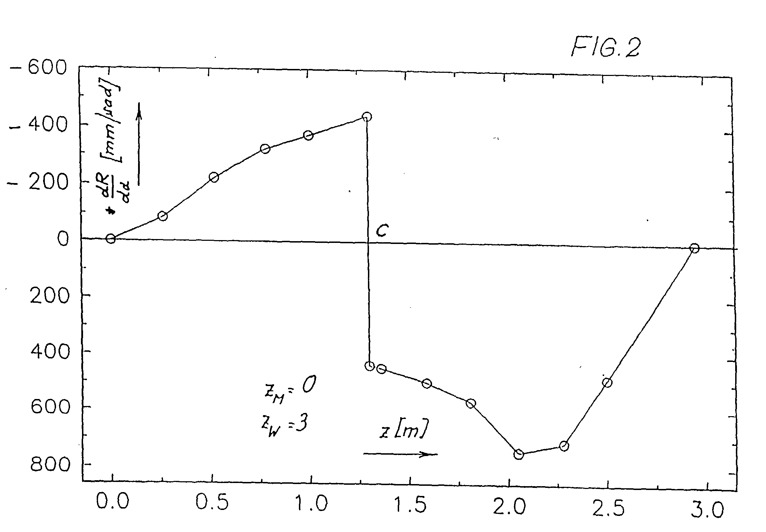

Den Graphen der Fig. 2 bis 5 liegt ein Ionenprojektor zugrunde, der als Linsen Drei-Elektroden-Gitterlinsen verwendet, wobei am Wafer hohe Energie von etwa 100 keV auftritt. Fig. 2 veranschaulicht die Funktion $dR/d\alpha$, welche zwischen Maske und Cross-over C abnimmt, wobei sich der Cross-over ca. 1,3 m nach der Maske befindet. Hinter dem Cross-over C ändert die Funktion ihr Vorzeichen und wird in der Waferebene (3 m von der Maske M entfernt) Null.

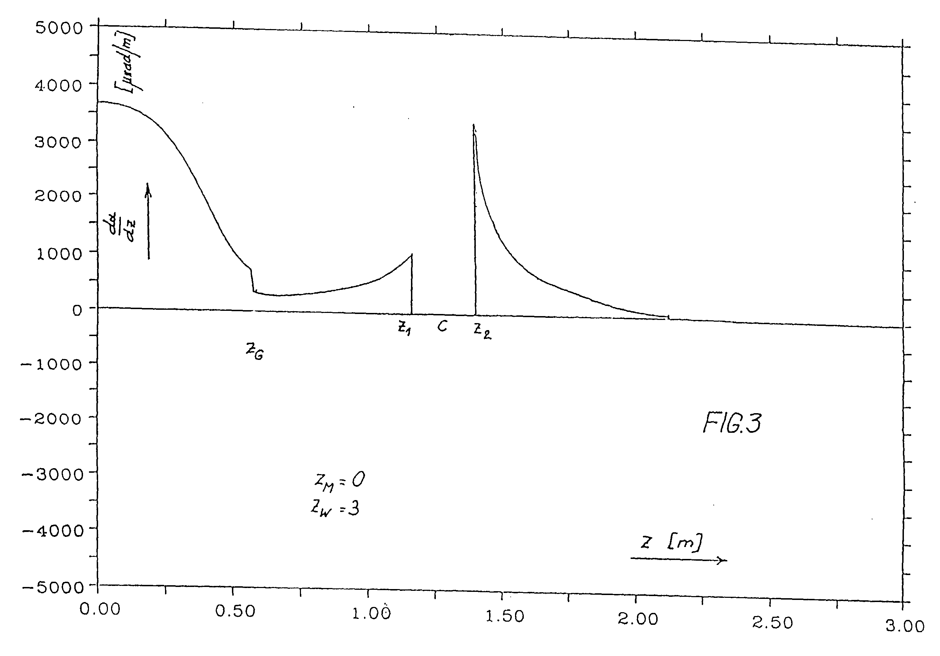

In Fig. 3 ist die Funktion $d\alpha/dz$ dargestellt. Im Bereich zwischen den Blenden, deren Ortskoordinaten $z_1$ und $z_2$ sind, wird der Wert dieser Funktion auf Null gesetzt. An der Stelle $z_G$ befindet sich das Gitter der Drei-Elektroden-Gitterlinse.

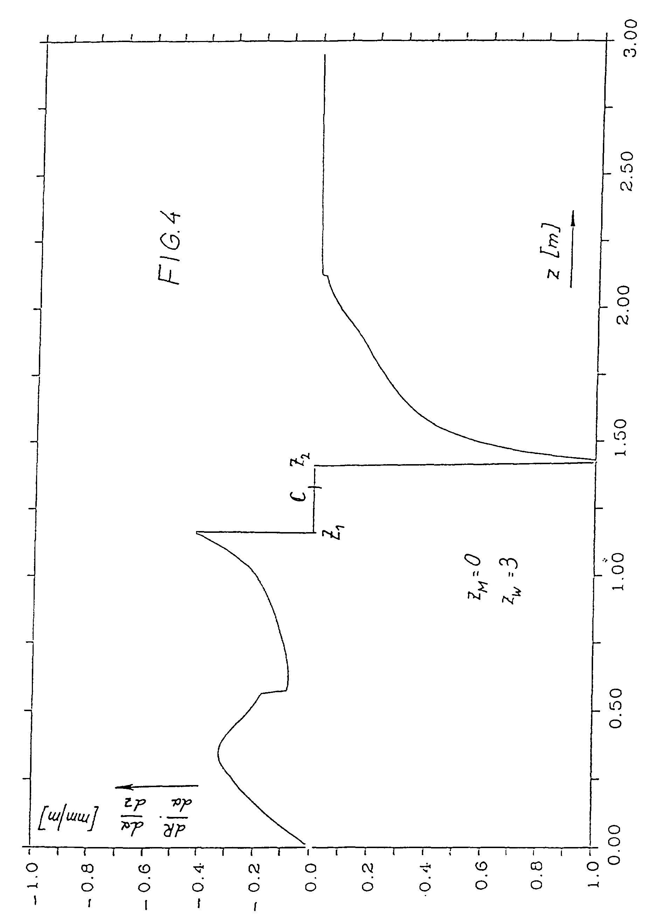

Fig. 4 zeigt den Graph des Produktes $(dR/d\alpha).(d\alpha/dz)$.

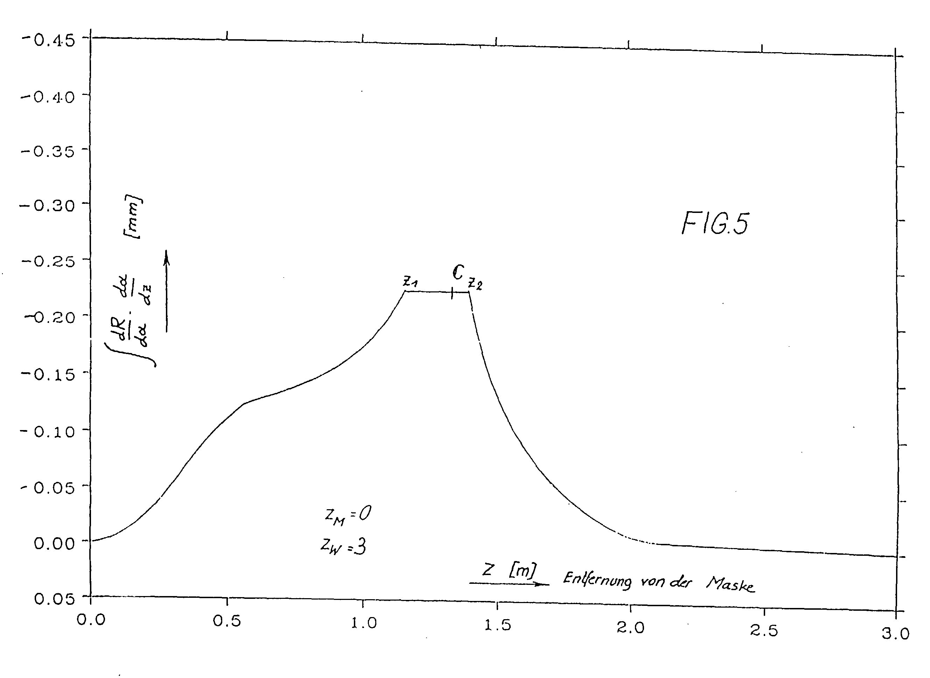

Schließlich veranschaulicht Fig. 5 das Integral für $\Delta R$.

Man erkennt, daß nach dem Crossover C die Wirkung der Raumladung abnimmt, also unabhängig von einer Zufuhr von entgegengesetzt geladenen Teilchen eine teilweise Kompensation der Raumladungswirkung stattfindet. Durch die Zufuhr einer ausreichenden Menge von entgegengesetzt geladenen Teilchen genau im Bereich zwischen $z_1$ und $z_2$ erreicht man, daß am Ort des Wafers (bei z=3m) die Wirkung der Raumladung auf die Strahlposition exakt gleich 0 wird.

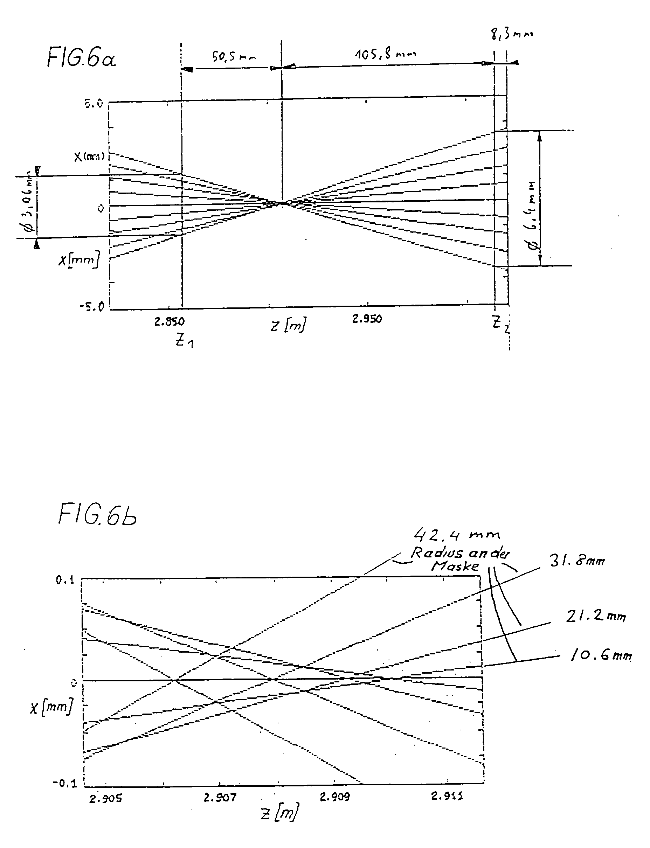

Den Fig. 6a und 6b liegt ein Innenprojektor mit einer sogenannten Zweielektroden-Gitterlinse zugrunde, wobei das Gitter von der Maske gebildet wird (siehe österreichische Patentanmeldung A 47/94 der gleichen Anmelderin vom gleichen Tage). Fig. 6a zeigt berechnete Ionenbahnen in Umgebung des Crossovers mit den Neutralisierungsgrenzen $z_1$, $z_2$. Wenn an diesen Orten Blenden angebracht werden, zwischen welchen Elektronen in genügender Anzahl zugeführt werden, so wird $\Delta R$ in Gleichung (3) zu Null. Fig. 6b stellt einen stark vergrößerten Ausschnitt von Fig. 6a dar, in dem man sieht, daß sich Strahlen mit verschiedenen Radien an der Maske an verschiedenen Stellen der optischen Achse kreuzen. Der in Fig. 6b gezeigte Bereich ist ca. 7 mm lang, wohingegen gemäß Fig. 6a der Abstand der ersten Blende vom Crossover größer als 50 mm ist. Damit ist für die bei $z_1$ in den Neutralisierungsbereich eintretenden Ionen die zu Gleichung (3) führende Annahme hinreichend gut erfüllt.

**Patentansprüche**

1. Projektionssystem für geladene Teilchen mit einer im Strahlengang der geladenen Teilchen angeordneten Maske mit transparenten Stellen, die unter Verwendung von im Strahlengang der geladenen Teilchen angeordneten Linsen auf einen Wafer abgebildet werden, wobei der Strahl der geladenen Teilchen zwischen der Maske und dem Wafer mindestens einen Cross-over, d.h. Kreuzung mit der optischen Achse, besitzt,
   **dadurch gekennzeichnet, daß**
   in einem definierten Bereich zwischen der Maske und dem Wafer geladene Teilchen mit einer zur Ladung der abbildenden Teilchen entgegengesetzten Ladung in den Strahlengang der abbildenden Teilchen zugeführt werden, wobei die den Bereich definierenden Grenzen so gewählt werden, daß der Absolutbetrag der integralen Wirkung der Raumladung auf die die Maskenstrukturen abbildenden Teilchen vor diesem Bereich in Strahlrichtung gesehen genau so groß ist wie der Absolutbetrag der integralen Wirkung der Raumladung nach diesem Bereich.

2. Projektionssystem nach Anspruch 1, dadurch gekennzeichnet, daß die abbildenden Teilchen positiv geladene Ionen und die Teilchen mit entgegengesetzter Ladung Elektronen sind.

3. Projektionssystem nach Anspruch 1, dadurch gekennzeichnet, daß die abbildenden Teilchen negativ geladene Ionen und die Teilchen mit entgegengesetzter Ladung positiv geladene Ionen sind.

4. Projektionssystem nach Anspruch 1, dadurch gekennzeichnet, daß als Spendeeinrichtung für die Teilchen mit der zu den abbildenden Teilchen entgegengesetzten Ladung eine LaB6-Kathode eingesetzt ist.

5. Projektionssystem nach Anspruch 4, dadurch gekennzeichnet, daß die LaB6-Kathode als ein den Ionenstrahl umgebender, indirekt beheizter LaB6-Zylinder ausgebildet ist.

6. Projektionssystem nach Anspruch 1, dadurch gekennzeichnet, daß als Spendeeinrichtung für die Teilchen mit der zu den abbildenden Teilchen entgegengesetzten Ladung eine Elektronenkanone eingesetzt ist, welche Elektronen durch eine Öffnung auf die Innenwand eines den Strahl umgebenden metallischen Schirmes aussendet, niederenergetische Sekundärelektronen generiert, welche den Ionenstrahl neutralisieren.

7. Projektionssystem nach Anspruch 1, dadurch gekennzeichnet, daß die abbildenden Teilchen Elektronen und die Teilchen mit entgegengesetzter Ladung positiv geladene Ionen sind.

8. Projektionssystem nach einem der Ansprüche 1 bis 7, dadurch gekennzeichnet, daß die entgegengesetzt zu den abbildenden Teilchen geladenen Teilchen in einem Bereich um den Crossover dem Strahlengang der abbildenden Teilchen zuführbar sind.

9. Projektionssystem nach Anspruch 8, dadurch gekennzeichnet, daß die Größe des Bereiches um den Crossover so groß gewählt wird, daß außerhalb dieses Bereiches für alle Bahnen von abbildenden Teilchen das Verhältnis der radialen Abstände je zweier Bahnen von der optischen Achse entlang der optischen Achse innerhalb von vorher festgelegten Fehlergrenzen konstant bleibt.

10. Projektionssystem nach einem der Ansprüche 1 bis 7, dadurch gekennzeichnet, daß zur Minimierung einer Restwirkung der Raumladung die Brechkräfte der Linsen in Abhängigkeit von der Gesamtstromstärke nachregelbar sind.

11. Projektionssystem nach einem der Ansprüche 1 bis 10, dadurch gekennzeichnet, daß zur Begrenzung des Bereichs, in dem neutralisierende Teilchen zugeführt werden, an jeder Seite des Bereiches mindestens je eine mit einer Spannungsquelle in Verbindung stehende Blende angeordnet ist, deren Öffnung jenes Strahlenbündel durchläßt, welche die von den transparenten Stellen in der Maske herrührenden Bildinformationen enthält.

12. Projektionssystem nach einem der Ansprüche 3 bis 7, dadurch gekennzeichnet, daß zu beiden Seiten des Crossovers eine Reihe von Blenden angeordnet sind, deren Potentiale individuell eingestellt werden können, womit der definierte Bereich für die Zufuhr der geladenen Teilchen variiert werden kann.

13. Projektionssystem nach einem der Ansprüche 3 bis 8, dadurch gekennzeichnet, daß die Öffnung der Blenden, die dem Cross-over näherliegen, kleiner ist als die Öffnung der Blenden, die vom Cross-over weiter abliegen.

**14.** Projektionssystem nach einem der Ansprüche 1 bis 13, dadurch gekennzeichnet, daß die transparenten Stellen der Maske Öffnungen sind.

**Claims**

**1.** Projection system for charged particles having a mask which is disposed in the beam path of the charged particles and which comprises transparent portions which are imaged onto a wafer using lenses disposed in the beam path of the charged particles, wherein the beam of the charged particles comprises at least one cross-over between the mask and the wafer, i.e. a crossing with the optical axis,
**characterized in that**
in a defined region between the mask and the wafer charged particles which are oppositely charged to the charge of the imaging particles are supplied into the beam path of the imaging particles, wherein the limits defining the region are selected such that the absolute value of the integral effect of the space charge on the particles imaging the mask structures before this region as seen in the beam direction is identical in size as the absolute value of the integral effect of the space charge after this region.

**2.** Projection system according to claim 1, **characterized in that** the imaging particles are positively charged ions and the oppositely charged particles are electrons.

**3.** Projection system according to claim 1, **characterized in that** the imaging particles are negatively charged ions and the oppositely charged particles are positively charged ions.

**4.** Projection system according to claim 1, **characterized in that** as a dispensing device for the particles which are charged oppositely to the imaging particles, a LaB6 cathode is provided.

**5.** Projection system according to claim 4, **characterized in that** the LaB6 cathode is realized as a La B6 cylinder indirectly heated and encompassing the ion beam.

**6.** Projection system according to claim 1, **characterized in that** as a dispensing device for the particles which are charged oppositely to the imaging particles, an electron cannon is provided which emits electrons through a hole onto the inner wall of a metal screen which encompasses the beam, generating low-energy secondary electrons which neutralize the ion beam.

**7.** Projection system according to claim 1, **characterized in that** the imaging particles are electrons and the oppositely charged particles are positively charged ions.

**8.** Projection system according to any one of claims 1 to 7, **characterized in that** the particles charged oppositely to the imaging particles are supplied to the beam path of the imaging particles in a region around the cross-over.

**9.** Projection system according to claim 8, **characterized in that** the size of the region around the cross-over is chosen such that outside this region for all paths of imaging particles the ratio of the radial distances of any two respective paths from the optical axis remains constant along the optical axis within previously fixed error limits.

**10.** Projection system according to any one of claims 1 to 7, **characterized in that** in order to minimize a residual effect of the space charge the refractive powers of the lenses can be readjusted depending on the total current intensity.

**11.** Projection system according to any one of claims 1 to 10, **characterized in that** in order to define the region in which neutralizing particles are supplied at least one diaphragm connected to a voltage source is disposed, respectively, on each side of the region and the hole of said diaphragm allows to pass through the beam of rays containing the image information originating from the transparent portions in the mask.

**12.** Projection system according to any one of claims 3 to 7, characterized in that a series of diaphragms are disposed on both sides of the cross-over and the potentials of said diaphragms can be adjusted individually, whereby the defined region for the provision of the charged particles can be varied.

**13.** Projection system according to any one of claims 3 to 8, **characterized in that** the hole in the diaphragm which is closer to the cross-over is smaller that the hole in the diaphragm positioned further away from the cross-over.

14. Projection system according to any one of claims 1 to 13, **characterized in that** the transparent portions of the masks are openings.

**Revendications**

1. Système de projection de particules chargées, comprenant un masque, qui est disposé dans le trajet du faisceau de particules chargées et qui comporte des parties transparentes, dont l'image est reproduite sur une plaquette au moyen de lentilles placées dans le trajet du faisceau de particules chargées, dans lequel le faisceau de particules chargées comprend au moins un croisement entre le masque et la plaquette, c'est-à-dire un croisement avec l'axe optique,
   caractérisé en ce que,
   dans une zone définie entre le masque et la plaquette, des particules chargées, dont les charges sont de signe contraire par rapport à la charge des particules de formation d'images, sont amenées dans le trajet du faisceau de particules de formation d'images, les limites définissant cette zone étant choisies de telle sorte que la valeur absolue de l'effet intégral de la charge d'espace sur les particules, reproduisant l'image des structures du masque, avant cette zone vue dans la direction du faisceau, soit identique quant à la taille à la valeur absolue de l'effet intégral de la charge d'espace après cette zone.

2. Système de projection selon la revendication 1, caractérisé en ce que les particules de formation d'images sont des ions à charge positive, tandis que les particules portant des charges de signe contraire sont des électrons.

3. Système de projection selon la revendication 1, caractérisé en ce que les particules de formation d'images sont des ions à charge négative, tandis que les particules portant des charges de signe contraire sont des ions à charge positive.

4. Système de projection selon la revendication 1, caractérisé en ce qu'il est prévu, en tant que dispositif de diffusion pour les particules, qui portent des charges de signe contraire par rapport aux particules de formation d'images, une cathode en LaB6.

5. Système de projection selon la revendication 4, caractérisé en ce que la cathode en LaB6 est réalisée sous la forme d'un cylindre en LaB6, indirectement chauffé et entourant le faisceau d'ions.

6. Système de projection selon la revendication 1, caractérisé en ce qu'il est prévu, en tant que dispositif de diffusion pour les particules, qui portent des charges de signe contraire par rapport aux particules de formation d'images, un canon à électrons, qui émet des électrons, par l'intermédiaire d'un trou, sur la paroi intérieure d'un écran métallique entourant le faisceau, produisant ainsi des électrons secondaires à faible énergie, qui neutralisent le faisceau d'ions.

7. Système de projection selon la revendication 1, caractérisé en ce que les particules de formation d'images sont des électrons, tandis que les particules portant des charges de signe contraire sont des ions à charge positive.

8. Système de projection selon l'une quelconque des revendications 1 à 7, caractérisé en ce que les particules portant une charge de signe contraire par rapport aux particules de formation d'images sont amenées dans le trajet du faisceau des particules de formation d'image dans une zone située autour du croisement.

9. Système de projection selon la revendication 8, caractérisé en ce que la taille de la zone entourant le croisement est choisie de telle manière que, à l'extérieur de cette zone, pour tous les trajets de particules de formation d'images, le rapport des distances radiales de deux trajets respectifs quelconques à l'axe optique demeure constant le long de l'axe optique, dans des limites d'erreurs préalablement fixées.

10. Système de projection selon l'une quelconque des revendications 1 à 7, caractérisé en ce que, afin de permettre de minimiser un effet résiduel de la charge d'espace, les degrés de réfraction des lentilles peuvent être réajustés en fonction de l'intensité totale du courant.

11. Système de projection selon l'une quelconque des revendications 1 à 10, caractérisé en ce que, pour définir la zone dans laquelle sont fournies des particules de neutralisation, il est prévu au moins un diaphragme, relié à une source de tension et disposé, respectivement, de chaque côté de cette zone, le trou dudit diaphragme laissant passer le faisceau de rayons contenant les données d'images, provenant des parties transparentes situées dans le masque.

12. Système de projection selon l'une quelconque des revendications 3 à 7, caractérisé en ce qu'une série de diaphragmes sont disposés des deux côtés du croisement et en ce que les potentiels desdits diaphragmes peuvent être réglés individuellement, ce qui permet de modifier la zone définie pour l'amenée des particules chargées.

13. Système de projection selon l'une quelconque des revendications 3 à 8, caractérisé en ce que le trou, prévu dans le diaphragme qui est le plus proche du croisement est plus petit que le trou situé dans le diaphragme plus éloigné du croisement.

14. Système de projection selon l'une quelconque des revendications 1 à 13, caractérisé en ce que les parties transparentes des masques sont des ouvertures.

EP 0 739 536 B1

## FIG.1

FIG.2

FIG.3

$z_M = 0$
$z_W = 3$

EP 0 739 536 B1

FIG.4

EP 0 739 536 B1

FIG.5

FIG.6a

50,5 mm   105,8 mm   8,3 mm

5.0

X (mm)

Ø 3,06 mm

0

Ø 6,4 mm

X [mm]

-5.0

2.850   Z [m]   2.950   Z₂

Z₁

FIG.6b

42.4 mm
Radius an der
Maske   31.8 mm

0.1

21.2 mm

10.6 mm

0

X [mm]

-0.1

2.905   2.907   2.909   2.911

Z [m]